(19) Europäisches Patentamt
European Patent Office
Office européen des brevets

(11) **EP 2 280 482 B1**

## (12) EUROPÄISCHE PATENTSCHRIFT

(45) Veröffentlichungstag und Bekanntmachung des Hinweises auf die Patenterteilung:
**16.05.2018   Patentblatt 2018/20**

(51) Int Cl.:
***H03H 17/02*** *(2006.01)*      ***H04R 25/00*** *(2006.01)*

(21) Anmeldenummer: **10168650.9**

(22) Anmeldetag: **07.07.2010**

(54) **Filterbankanordnung für eine Hörvorrichtung**

Filter bank assembly for a hearing device

Système d'ensemble de filtre pour un dispositif auditif

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **09.07.2009   DE 102009032434**
**07.08.2009   DE 102009036610**

(43) Veröffentlichungstag der Anmeldung:
**02.02.2011   Patentblatt 2011/05**

(73) Patentinhaber: **Sivantos Pte. Ltd.**
**Singapore 539775 (SG)**

(72) Erfinder:
• **Kurbiel, Thomas**
**45739 Erkenschwik (DE)**
• **Goeckler, Heinz, Pr.**
**71522 Backnang (DE)**
• **Puder, Henning, Dr.**
**91052 Erlangen (DE)**
• **Bäuml, Robert**
**90542 Eckental (DE)**
• **Sörgel, Wolfgang**
**91052 Erlangen (DE)**

(74) Vertreter: **FDST Patentanwälte**
**Nordostpark 16**
**90411 Nürnberg (DE)**

(56) Entgegenhaltungen:
**US-A1- 2005 185 798      US-A1- 2007 276 656**
**US-B1- 6 393 083**

• **BRENNAN R ET AL: "A flexible filterbank structure for extensive signal manipulations in digital hearing aids", CIRCUITS AND SYSTEMS, 1998. ISCAS '98. PROCEEDINGS OF THE 1998 IEEE INTERNATIONAL SYMPOSIUM ON MONTEREY, CA, USA 31 MAY-3 JUNE 1998, NEW YORK, NY, USA,IEEE, US, Bd. 6, 31. Mai 1998 (1998-05-31), Seiten 569-572, XP010289846, DOI: 10.1109/ISCAS.1998.705338 ISBN: 978-0-7803-4455-6**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Filterbankanordnung für eine Hörvorrichtung, wobei bei der Filterbankanordnung Filter einer Analysefilterbank mit entsprechenden Filtern einer Synthesefilterbank paarweise gekoppelt sind, so dass durch jedes Paar der gekoppelten Filter ein Kanal gebildet ist. Unter einer Hörvorrichtung wird hier insbesondere ein Hörgerät verstanden.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Hörgerät mit externem Hörer (RIC: receiver in the canal) und In-dem-Ohr-Hörgeräte (IdO), z.B. auch Concha-Hörgeräte oder Kanal-Hörgeräte (ITE, CIC), bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder akustisch, mechanisch oder elektrisch.

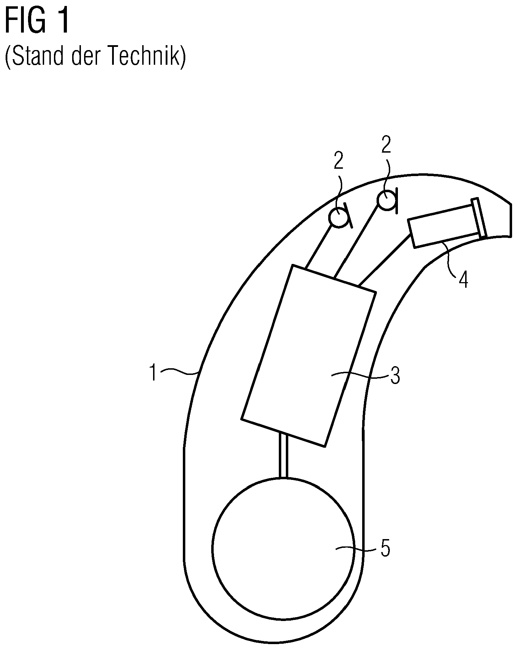

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Energieversorgung des Hörgeräts und insbesondere die der Signalverarbeitungseinheit 3 erfolgt durch eine ebenfalls ins Hörgerätegehäuse 1 integrierte Batterie 5.

Das Dokument US 2005/0185798 A1 betrifft ein Verfahren zu Korrektur von Gruppenlaufzeiten von Geräuschen für Hörbehinderte. Das Verfahren bestimmt eine Gruppenlaufzeit, wie sie für das Gehör von Personen ohne Hörverlust zu erwarten ist und verzögert die Signale in einzelnen Kanälen derart, dass der Hörgeschädigte zusammen mit einer veränderten Phasenwahrnehmung des geschädigten Gehörs eine zu einem Gesunden vergleichbare Phasenverzögerung erfährt.

Dokument US 2007/0276656 A1 beschreibt ein Verfahren und System zur Verarbeitung von Audiosignalen. In einer Analysefilterbank werden Signale in Frequenzkanäle zerlegt, zur Bearbeitung bereitgestellt und anschließend in einem Rekonstruktionsmodul wieder zu einem Ausgangssignal zusammengesetzt.

Die Druckschrift BRENNAN R ET AL:"A flexible filterbank structure for extensive signal manipulations in digital hearing aids" (CIRCUIT AND SYSTEMS, 1998. ISCAS ,98. PROCEEDINGS OF THE 1998 IEEE INTERNATIONAL SYMPOSION ON MONTEREY, CA, USA 31 MAY-3 JUNE 1998, NEW YORK, NY, USA, IEEE, US, Bd.6, 31.Mai 1998, Seiten 569-572, XP010289846, DOI:10.1109/ISCAS.1998.705338; ISBN:978-0-7803-4455-6) beschreibt ein Filterbanksystem, das auch für Hörgeräte geeignet ist.

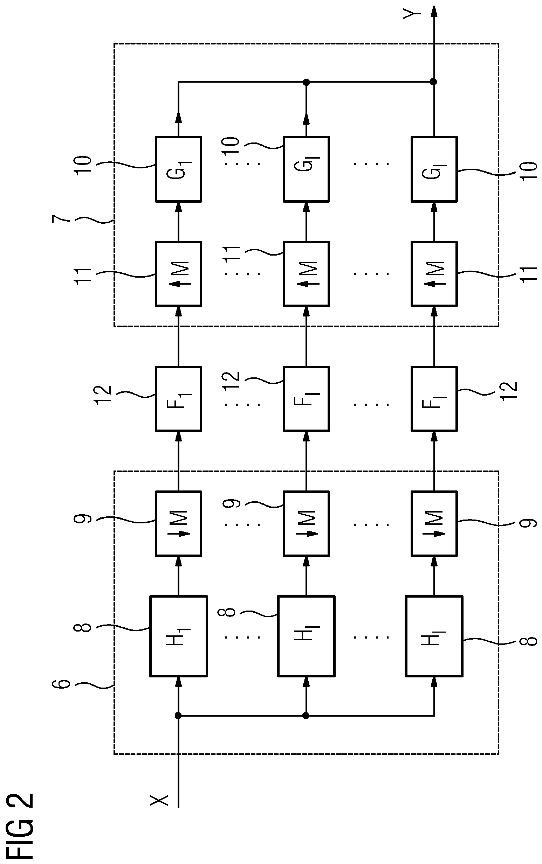

Ein Hörgerät wird insbesondere dazu verwendet, eine Hörschwäche eines Trägers des Hörgeräts durch Verstärken des Mikrofonsignals auszugleichen. Da eine Hörschwäche typischerweise abhängig von der Frequenz eines Schallsignals unterschiedlich stark ausgeprägt ist, ist es zum Verstärken des Mikrofonsignals nötig, selbiges in seine spektralen Bestandteile zu zerlegen und die Verstärkung frequenzabhängig vorzunehmen. Für die spektrale Zerlegung des Mikrofonsignals in Teilbandsignale kommt häufig eine digitale Filterbankanordnung mit einer Analysefilterbank und einer Synthesefilterbank zum Einsatz. In FIG 2 ist ein Signalflussgraph für eine typische Filterbankanordnung eines Hörgeräts dargestellt. Die Filterbankanordnung umfasst eine Analysefilterbank 6 und eine Synthesefilterbank 7. Die Analysefilterbank 6 setzt sich aus insgesamt I Filtern 8 zusammen, von denen in FIG 2 insgesamt drei Filter $H_1$, $H_l$, $H_I$ dargestellt sind. Im folgenden wird der Index auch dazu verwendet auf alle Filter 8 als Filter $H_l$, l=1...I, zu verweisen. Eine typische Filterbankanordnung kann beispielsweise I = 64 Filter 8 umfassen. Bei dem Filter $H_1$ handelt es sich um einen Tiefpassfilter, die übrigen Filter sind Bandpassfilter mit unterschiedlichen Mittenfrequenzen.

Die Analysefilterbank 6 gibt die durch die einzelnen Filter 8 gefilterten Signale mit einer verringerten Taktrate aus. In FIG 2 ist dies durch Taktratenreduzierer 9 symbolisiert, bei denen jeweils an einem Ausgang digitale Werte mit einer Rate ausgegeben werden, die im Verhältnis zur Rate der an einem Eingang eingelesenen Werte um den Faktor 1/M geringer ist. Ein typischer Wert für diese Unterabtastung ist M = 16. Die Taktratenreduktion kann erreicht werden, indem von M aufeinanderfolgenden empfangenen Werten M-1 Werte nicht ausgegeben werden.

Die Synthesefilterbank 7 umfasst ebenfalls I Filter 10, bei denen ein spektraler Durchlassbereich demjenigen Durchlassbereich des Filters der Analysefilterbank 6 entspricht, mit dem das jeweilige Filter 10 der Synthesefilterbank 7 gekoppelt ist. Somit ist das in FIG 2 gezeigte Filter $G_1$ ein Tiefpass, dessen Durchlassbereich dem Durchlassbereich des Tiefpasses $H_1$ entspricht. Genauso entsprechen die Durchlassbereiche der Bandpässe $G_l$ und $H_l$, l=2...I, einander.

Von den Bandpässen sind in FIG 2 einige lediglich durch Auslassungspunkte angedeutet. Durch die Synthesefilterbank 7 wird typischerweise auch eine Taktratenerhöhung bewirkt. Dies ist in FIG 2 durch Taktratenerhöher 11 symbolisiert. Wo sich die Taktratenreduzierer 9 und die Taktratenerhöher 11 bei einer tatsächlichen Filterbankanordnung befinden, hängt vom Bautyp derselben ab.

Durch die Analysefilterbank 6 wird bewirkt, dass ein digitales Eingangssignal X in I Teilbandsignale aufgeteilt wird. Jedes Filter $H_l$, I = 1...I, filtert dazu ein bestimmtes spektrales Band aus dem Eingangssignal X heraus. Dazu weist sein Frequenzgang einen Durchlassbereich, einen Übergangsbereich und einen Sperrbereich auf. Bei einem Teilbandsignal handelt es sich üblicherweise um eine Folge von komplexen Zahlenwerten. Mit Hilfe von Multiplizierern 12 ist es dann möglich, die einzelnen Teilbänder zu verstärken. Die Verstärkungsfaktoren der Multiplizierer 12 sind in FIG 2 als Faktoren $F_1$, $F_l$, $F_I$ angegeben. Die verstärkten Teilbandsignale werden mittels der Synthesefilterbank zu Signalen mit einer höheren Taktrate umgewandelt und anschließend zu einem Ausgangssignal Y kombiniert.

Da jedes Filter $H_l$, I = 1...I, der Analysefilterbank 6 ein bestimmtes spektrales Band aus dem Eingangssignal X herausfiltert, das anschließend separat bearbeitet wird, werden die einzelnen Signalpfade zwischen einem Filter $H_l$ und dem entsprechenden Filter $G_l$ auch als Kanäle der Filterbankanordnung bezeichnet. Ein Kanal wird im Folgenden durch den Index I der zugehörigen Filter $H_l$ und $G_l$ bezeichnet.

Um eine hohe auditive Qualität des Ausgangssignals Y zu gewährleisten, muss bei jedem Kanal I das Filterpaar $H_l$, $G_l$ aufeinander abgestimmt sein. Geeignete Filterpaare lassen sich mit unterschiedlichen Entwurfsverfahren für Filterbankanordnungen finden. Ein bekanntes Standard-Entwurfsverfahren ist z.B. das Verfahren von Dam, Nordholm Cantoni und de Haan (H.H. Dam, S. Nordholm, A. Cantoni und J.M. de Haan: "Iterative method for the design of DFT filter bank", IEEE Transactions on Circuits and Systems II: Express Briefs, Volume 51, Issue 11, Nov. 2004, Seiten: 581 - 586).

Die Entwurfsverfahren stellen insbesondere sicher, dass ein Filterpaar $H_l$, $G_l$ eine möglichst geringe Verzögerung eines über den entsprechenden Kanal I tragenden Signals bewirkt. Dabei muss auch darauf geachtet werden, dass bei allen Kanälen I, I = 1...I, in ihren jeweiligen Durchlassbereichen die Verzögerung einem Sollwert entspricht, der für alle Kanäle gleich ist, so dass in dem Ausgangssignal Y einzelne spektrale Anteile nicht zeitlich gegeneinander versetzt sind. Eine Verzögerung wird hierbei oft in Taktzyklen des digitalen Systems gemessen.

Um die Güte einer Filterbankanordnung zu bewerten, kann für die Filterbankanordnung oder für Bestandteile derselben eine Gruppenlaufzeit ermittelt werden. Eine Gruppenlaufzeit gibt an, welche Verzögerung ein einzelner spektraler Anteil mit einer bestimmten Frequenz f eines Eingangssignals X erfährt, wenn er über eine Filterbankanordnung in einen entsprechenden spektralen Anteil eines Ausgangssignals Y abgebildet wird. Die Gruppenlaufzeit ist häufig nicht für absolute Frequenzen f sondern durch eine Normierung auf die Abtastrate $f_A$ des zugehörigen digitalen Systems für die Kreisfrequenzen $\Omega$ bestimmt. $\Omega$ ist dabei gemäß der folgenden Gleichung 1 definiert:

$$\text{Gleichung 1: } \Omega = 2\pi \; f/f_A$$

Zum Bestimmen der Güte wird neben der Gruppenlaufzeit für die gesamte Filterbankanordnung auch die Verzerrungsfunktion untersucht. Dieses Maß lässt ebenfalls auf die Güte der gesamten Filterbankanordnung schließen. So kann z. B. eine Verzerrungsfunktion $T(e^{j\Omega})$ gemäß der folgenden Gleichung 2 ermittelt werden:

$$\text{Gleichung 2: } T(e^{j\Omega}) = 1/M \; [\textstyle\sum_{l=1}^{I} F_l \; H_l(e^{j\Omega}) \; G_l(e^{j\Omega})]$$

Gleichung 2 legt fest, dass bei der Verzerrungsfunktion $T(e^{j\Omega})$ für jede Frequenz $\Omega$ der Einfluss der komplexen Übertragungsfunktion $H_l(e^{j\Omega})$ der Filter der Analysefilterbank und der komplexen Übertragungsfunktion $G_l(e^{j\Omega})$ der Filter der Synthesefilterbank berücksichtigt wird. Außerdem ist der Einfluss der Faktoren $F_l$ berücksichtigt. Aus der Verzerrungsfunktion $T(e^{j\Omega})$ kann ein Wert für eine Gruppenlaufzeit $\tau(\Omega)$ gemäß der folgenden Gleichung 3 berechnet werden:

$$\text{Gleichung 3: } \tau(\Omega) = -1 \; \partial \text{arg}\{T(e^{j\Omega})\} \; / \; \partial\Omega$$

Der Operator arg{} gibt dabei an, dass von der Verzerrungsfunktion $T(e^{j\Omega})$ nur die Phase der komplexen Werte zu betrachten ist. Der Operator $\partial/\partial\Omega$ steht für die Ableitung nach $\Omega$. Die Gruppenlaufzeit $\tau(\Omega)$ ist also die Ableitung des Phasengangs der Verzerrungsfunktion $T(e^{j\Omega})$ nach der normierten Kreisfrequenz $\Omega$. Die Gruppenlaufzeit $\tau(\Omega)$ ist ein Maß dafür, wie stark einzelne spektrale Bestandteile eines durch die Filterbankanordnung übertragenen Signals gegeneinander zeitlich verschoben werden.

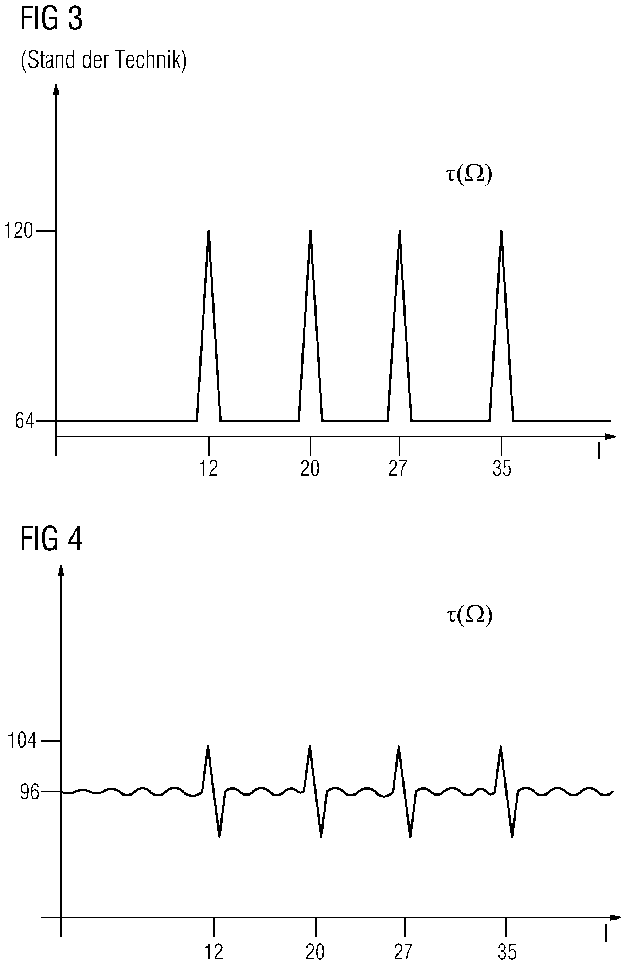

In FIG 3 ist die Gruppenlaufzeit $\tau(\Omega)$ für eine Filterbankanordnung aus dem Stand der Technik gezeigt, die in einem Hörgerät verwendet wird, um eine frequenzabhängige Verstärkung eines Mikrofonsignals zu ermöglichen. Der Aufbau der Filterbankanordnung entspricht demjenigen gemäß der FIG 2. Als Verstärkungsfaktoren $F_l$ wurden dabei die folgenden Werte gewählt:

$$F_l = \quad 1 \text{ für } l = \quad 1 \ldots 11,$$

$$F_l = \quad 50 \text{ für } l = 12 \ldots 19,$$

$$F_l = 300 \text{ für } l = 20 \ldots 27,$$

$$F_l = \quad 15 \text{ für } l = 28 \ldots 35,$$

$$F_l = \quad 1 \text{ für } l = 36 \ldots 64.$$

Die Gruppenlaufzeit $\tau(\Omega)$ ist in FIG 3 für die verschiedenen Werte $\Omega$ aufgetragen. Auf der horizontalen Achse ist dabei nicht der Wert $\Omega$, sondern für einige Werte von $\Omega$ lediglich der Index l des entsprechenden Kanals aufgetragen. Aus dem Diagramm der FIG 3 geht hervor, dass die Gruppenlaufzeit $\tau(\Omega)$ für die meisten Frequenzen $\Omega$ den Wert 64 aufweist. Allerdings weicht die Gruppenlaufzeit $\tau(\Omega)$ an den Übergängen zwischen Kanälen, für die sich die Faktoren $F_l$ gemäß der obigen Auflistung jeweils stark voneinander unterscheiden, signifikant von dem Wert 64 in unerwünschter Weise ab. An den Übergangsstellen weist die Gruppenlaufzeit einen Wert von nahezu 120 auf. Die großen Unterschiede zwischen den Gruppenlaufzeiten $\tau(\Omega)$ für verschiedene Frequenzen $\Omega$ nimmt ein Benutzer des Hörgeräts als unerwünschte Verzerrung des Ausgangssignals wahr.

Es ist Aufgabe der vorliegenden Erfindung, bei einer Filterbankanordnung für eine Hörvorrichtung eine Verstärkung von Signalen in einzelnen Kanälen der Filterbankanordnung zu ermöglichen, ohne dass dabei wahrnehmbare Verzerrungen aufgrund von starken Abweichungen der Gruppenlaufzeit der Filterbankanordnung für einzelne Frequenzen hervorgerufen werden.

Die Aufgabe wird durch eine Filterbankanordnung gemäß Patentanspruch 1 gelöst. Vorteilhafte Weiterbildungen der erfindungsgemäßen Filterbankanordnung sind durch die Unteransprüche gegeben.

Bei der erfindungsgemäßen Filterbankanordnung sind Filter einer Analysefilterbank mit entsprechenden Filtern einer Synthesefilterbank paarweise gekoppelt, wobei durch jedes Paar der gekoppelten Filter ein Kanal gebildet ist. Für wenigstens einen derartig gebildeten Kanal sind dabei Mittel vorgesehen, um eine Phase eines über den Kanal übertragenen Signals derart zu verändern, dass eine Differenz zwischen einer Gruppenlaufzeit der Filterbankanordnung und einem vorgebbaren Sollwert für wenigstens eine vorbestimmte Frequenz reduziert wird. Indem über die Mittel zum Verändern Einfluss auf die Phase des Signals wenigstens eines Kanals genommen wird, ergibt sich der Vorteil, dass sich eine Abweichung der Gruppenlaufzeit der gesamten Filterbankanordnung von einem Sollwert gezielt reduzieren lässt. Als Sollwert ist hierbei derjenige Wert zu verstehen, den die Gruppenlaufzeiten der Filterbankanordnung für möglichst viele Frequenzen aufweisen sollen, so dass sich eine geringe Verzerrung des Signals ergibt.

Die Art der benötigten Veränderung der Phase des Signals kann bei einer gegebenen Filterbankanordnung durch numerische Verfahren ermittelt werden. Bevorzugt handelt es sich bei der Veränderung um einen konstanten Phasenbeitrag, der auf die Phase des komplexen Signals eines Kanals aufaddiert wird. Die Form der Veränderung kann dann im Voraus bestimmt sein. Die Änderung der Phase kann aber auch mittels einer Adaption während eines Betriebes der Filterbankanordnung vorgenommen werden.

Die Mittel zum Verändern der Phase lassen sich dabei in vielen unterschiedlichen Varianten bereitstellen. Bei der erfindungsgemäßen Filterbankanordnung ist wenigstens ein Filter der Analysefilterbank über eine Skalierungseinrichtung mit dem entsprechenden Filter der Synthesefilterbank gekoppelt, wobei mittels der Skalierungseinrichtung ein Teilbandsignal mit einem Faktor multiplizierbar ist. Als Mittel zum Verändern der Phase ist dabei vorgesehen, dass bei der Skalierungseinrichtung der Faktor einem komplexen Wert entspricht, dessen Phase derart bestimmt ist, dass für wenigstens eine vorbestimmte Frequenz die Differenz zwischen der Gruppenlaufzeit der Filterbankanordnung und dem vorgebbaren Sollwert reduziert wird.

Indem die Filter eines Paares von gekoppelten Filtern über eine Skalierungseinrichtung gekoppelt sind, die ein Teilbandsignal in dem entsprechenden Kanal mit einem komplexen Faktor multiplizieren kann, lässt sich eine Verstärkung des Teilbandsignals in besonders einfacher Weise mit einer Veränderung der Phase desselben kombinieren.

Durch Verwenden einer Skalierungseinrichtung mit einem komplexen Faktor ergibt sich des Weiteren der Vorteil, dass eine Möglichkeit gegeben ist, um auf sehr einfache Weise durch routinemäßiges Experimentieren herausfinden zu können, welche Veränderung der Phase für eine gegebene Filterbankanordnung eine gewünschte Reduzierung einer Abweichung der Gruppenlaufzeit der Filterbankanordnung von dem Sollwert ergibt. Erfindungsgemäß ist dabei vorgesehen, bei der Skalierungseinrichtung die Phase des Faktors abhängig von einer Summe aus einer mittleren Gruppenlaufzeit des zugeordneten Filters der Analysefilterbank und einer mittleren Gruppenlaufzeit des entsprechenden Filters der Synthesefilterbank zu bestimmen. Unter einer mittleren Gruppenlaufzeit des jeweiligen Filters ist dabei der Mittelwert der Gruppenlaufzeiten zu verstehen, der für all diejenigen Frequenzen gebildet ist, die zum Durchlass bzw. zum Übergangsbereich des Filters gehören. Wird die Phase des Faktors auf diese Weise bestimmt, ergibt sich der Vorteil, dass die Abweichung der Gruppenlaufzeit gezielt auf einen kleinen Wert reduziert werden kann. Bei der erfindungsgemäßen Filterbankanordnung entspricht eine durch die Phase des Faktors bewirkte Verzögerung eines über die Skalierungseinrichtung übertragenen Teilbandsignals zusammen mit der Summe der mittleren Gruppenlaufzeiten einem Wert, der ein ganzzahliges Vielfaches der Anzahl der Kanäle der Filterbankanordnung ist. Dadurch lässt sich in vorteilhafter Weise die Differenz minimieren.

Bei einer bevorzugten Ausführungsform der erfindungsgemäßen Filterbankanordnung ist die Analysefilterbank eine komplex modulierte Polyphasenfilterbank mit einem ersten Prototypfilter, aus dem die Filter der Analysefilterbank jeweils in Abhängigkeit von einem Kennwert l für den Kanal gebildet werden, und bei der die Synthesefilterbank ebenfalls eine komplex modulierte Polyphasenfilterbank mit einem zweiten Prototypfilter ist.

Bei dieser Ausführungsform hängt bei der Skalierungseinrichtung die Phase des Faktors ab von dem Kennwert l für den Kanal, der Anzahl l der Kanäle der Filterbankanordnung und der Summe aus der mittleren Gruppenlaufzeit des ersten Prototypfilters und der mittleren Gruppenlaufzeit des zweiten Prototypfilters. Bei dem Kennwert für den Kanal handelt es sich dabei um denjenigen Faktor, der nötig ist, um festzulegen, wie weit das Prototypfilter durch die komplexe Modulation entlang der Frequenz verschoben werden soll, um das Filter der Analysefilterbank für den entsprechenden Kanal zu bilden.

Durch Verwenden einer komplex-modulierten Filterbank ergibt der Vorteil, dass zum Bestimmen der Phase des Faktors lediglich zwei Filter, nämlich das Prototypfilter der Analysefilterbank und das Prototypfilter der Synthesefilterbank, untersucht werden müssen. Dies macht es besonders leicht, bei einer entsprechenden Filterbankanordnung die Abweichungen der Gruppenlaufzeiten von dem Sollwert in gewünschter Weise zu verringern.

Ein besonderer Vorteil ergibt sich dabei, wenn das erste Prototypfilter und das zweite Prototypfilter jeweils ein FIR-Filter (FIR - Finite Impulse Response), gegebenenfalls auch ein linearphasiges FIR-Filter, ist. Bei einem FIR-Filter lässt sich eine mittlere Gruppenlaufzeit einfach und dabei auch genau berechnen. Ein linearphasiges Filter zeichnet sich durch eine konstante Gruppenlaufzeit aus.

Bei einer anderen Weiterbildung der erfindungsgemäßen Filterbankanordnung ist bei wenigstens einem Paar der gekoppelten Filter das Filter der Analysefilterbank und das Filter der Synthesefilterbank jeweils ein FIR-Filter, wobei die Summe aus den mittleren Gruppenlaufzeiten der beiden Filter ein ganzzahliges Vielfaches der Anzahl der Kanäle der Filterbankanordnung ist. Dadurch ergibt sich der Vorteil, dass bereits durch Verwendung dieser Filter die Gruppenlaufzeiten der Filterbankanordnung für unterschiedliche Frequenzen nur geringfügig voneinander abweichen. Dadurch wird es insbesondere ermöglicht, bei der Skalierungseinrichtung als Faktor einen reellen Wert zu verwenden, wodurch sich im Vergleich zu einer Skalierungseinrichtung mit einem komplexen Faktor eine Reduktion der Anzahl der Rechenoperationen beim Prozessieren eines Signals ergibt. Ein ganzzahliges Vielfaches der Anzahl l der Kanäle ergibt sich dabei als kl mit k=0, 1, 2,....

Bevorzugt ist dabei bei dem wenigstens einen Filterpaar der gekoppelten Filter das Filter der Analysefilterbank und das Filter der Synthesefilterbank jeweils ein linearphasiges FIR-Filter, wobei die Summe der Filterordnungen ein ganzzahliges Vielfaches der doppelten Anzahl der Kanäle der Filterbankanordnung ist. Die Filterordnung ergibt sich dabei als die Anzahl der Koeffizienten des FIR-Filters minus Eins.

Bei dieser Weiterbildung der Filterbankanordnung lässt sich die Bedingung, dass die Summe aus den mittleren Gruppenlaufzeiten ein ganzzahliges Vielfaches der Anzahl der Kanäle sein soll, besonders leicht durch eine Wahl entsprechend langer FIR-Filter erfüllen.

Bei einer anderen Weiterbildung der erfindungsgemäßen Filterbankanordnung ist als Mittel zum Verändern der Phase bei wenigstens einem Paar der gekoppelten Filter als ein erstes Filter des Paares ein FIR-Filter vorgesehen, das durch eine Folge von Koeffizienten bestimmt ist, welche sich ergibt, wenn eine Folge von Koeffizienten eines FIR-Filters umgekehrt wird, das einem auf das zweite Filter des Paares abgestimmten Filter entspricht. Mit anderen Worten lässt sich eine geeignete Veränderung der Phase bei einigen FIR-Filtern dadurch erreichen, dass im Vergleich zu einer Filterbankanordnung aus dem Stand der Technik einfach die Koeffizienten der FIR-Filter in umgekehrter Reihenfolge verwendet werden.

Werden also bei einer Filterbankanordnung Filter der Analysefilterbank und der Synthesefilterbank mittels eines Standard-Entwurfsverfahrens für abgestimmte Filter eines Analyse-Synthese-Filterbank entworfen, so kann zum Lösen der oben genannten Aufgabe vorgesehen werden, die Koeffizienten wenigstens eines der Filter in umgekehrter Reihenfolge in der Filterbankanordnung zu verwenden. Als Vorteil ergibt sich, dass die gewünschte Veränderung der Phase ohne jeglichen zusätzlichen Aufwand bewirkt wird.

Bevorzugt wird dabei bei wenigstens einer der Filterbänke eine Einrichtung zum Berechnen einer diskreten Fourier-Transformation (DFT) verwendet. Im Vergleich zu Filterbankanordnungen aus dem Stand der Technik, die häufig mittels der inversen diskreten Fourier-Transformation (IDFT) operieren, kann durch Verwenden der diskreten Fourier-Transformation (DFT) eine Filterbankanordnung geschaffen werden, deren Aufbau besonders einfach ist und bei der dennoch die Gruppenlaufzeiten der Filterbankanordnung für unterschiedliche Frequenzen nur geringfügig voneinander abweichen.

Anstelle von oder zusätzlich zu einer umgekehrten Reihenfolge der Koeffizienten der FIR-Filter ist bei einer anderen Weiterbildung der erfindungsgemäßen Filterbankanordnung vorgesehen, wenigstens eine komplex-modulierte, gleichförmige Filterbank vorzusehen, bei der Filter der Filterbank aus einem Prototypfilter jeweils durch eine komplexe Modulation mittels einer DFT oder einer IDFT gebildet sind, wobei die Filterbank dazu ausgebildet ist, als Mittel zum Verändern der Phase eine Reihenfolge von Werten eines Eingangssignals und/oder eines Ausgangssignals einer Einrichtung zum Berechnen der DFT oder IDFT umzukehren. Durch Vertauschen der Reihenfolge der Abtastwerte eines Eingangssignals oder der berechneten Werte eines Ausgangssignals wird derselbe vorteilhafte Effekt erzielt wie beim Vertauschen der Koeffizienten eines FIR-Filters.

Bei einer anderen vorteilhaften Weiterbildung der erfindungsgemäßen Filterbankanordnung ist bei allen Paaren der gekoppelten Filter die Summe aus der mittleren Gruppenlaufzeit des Filters der Analysefilterbank und der mittleren Gruppenlaufzeit des entsprechenden Filters der Synthesefilterbank gleich. Dadurch ergibt sich der Vorteil, dass die Abweichung der Gruppenlaufzeiten von dem Sollwert für alle Frequenzen, die mit der Filterbankanordnung prozessiert werden können, mit geringen Aufwand minimiert werden kann.

Dabei ist die Summe aus den mittleren Gruppenlaufzeiten bevorzugt ein ganzzahliges Vielfaches der Anzahl der Kanäle. Dadurch ergibt sich der besondere Vorteil, dass sich die Minimierung ohne jeden zusätzlichen Aufwand von selbst ergibt.

Die Erfindung wird im Folgenden anhand von Beispielen näher erläutert. Dazu zeigen:

FIG 1     eine schematische Darstellung eines Aufbaus eines Hörgeräts;

FIG 2     einen Signalflussgraphen für eine Filterbankanordnung;

FIG 3     ein Diagramm mit einem Graphen der Gruppenlaufzeit $\tau(\Omega)$, wie er sich für eine Filterbankanordnung gemäß dem Stand der Technik ergibt;

FIG 4     ein Diagramm mit einem Graphen der Gruppenlaufzeit $\tau(\Omega)$, wie er sich für eine Ausführungsform der erfindungsgemäßen Filterbankanordnung ergibt; und

FIG 5     einen Signalflussgraphen für eine Analysefilterbank einer Ausführungsform der erfindungsgemäßen Filterbankanordnung, wobei bei der Analysefilterbank eine Reihenfolge von Werten eines Eingangssignals umkehrbar ist.

In FIG 4 ist ein Diagramm mit einem Graphen für eine Gruppenlaufzeit $\tau(\Omega)$ dargestellt, wobei die Achsen des Diagramms den Achsen des in FIG 3 dargestellten Diagramms entsprechen. Vom Aufbau her entsprechen diese beiden Filterbänke der in FIG 2 dargestellten Filterbank.

Die Filterbank der FIG 4 besteht dabei aus einer komplex-modulierten Polyphasenfilterbank mit $H_1$ als Prototyp-Tiefpassfilter. Die Bandpassfilter $H_2$ bis $H_l$ entsprechen vom Betragsgang dem Filter $H_1$, wobei jedoch die Mittenfrequenz eines Bandpasses jeweils durch eine komplexe Modulation zur einer Frequenz $\Omega = 2\,\pi\,(l-1)/l$ verschoben sind. Im Unterschied zu der Filterbank, die dem Graphen der FIG 3 zugrunde liegt, weist die zu dem Graphen der FIG 4 gehörige Filterbank als Faktoren für die Multiplizierer 12 komplexe Werte $\underline{F}_l$, 1=1...I, auf, die nach der folgenden Gleichung 4 gebildet sind:

$$\texttt{Gleichung 4:}\ \underline{F}_l = F_l\ e^{-j\ 2\ \pi\ (l-1)\ r\ /\ I}$$

Die reellen Faktoren $F_l$, 1=1...I, sind dieselben, wie sie auch bei der Filterbank verwendet werden, die dem Graphen der FIG 3 zugrunde liegt.

Bei der Filterbankanordnung ist die Phase jedes Faktors $\underline{F}_l$, 1=1...I, berechnet als -2 $\pi$ (l-1) r / I. Sie hängt damit von dem Kanalindex l ab, durch den auch die Mittenfrequenz des entsprechenden Kanals bestimmt ist. Die Phase jedes komplexen Faktors $\underline{F}_l$ hängt des Weiteren von einem ganzzahligen Wert r ab, der aus einer mittleren Gruppenlaufzeit $\tau_H$ des Tiefpass-Prototypfilters $H_1$ und einer mittleren Gruppenlaufzeit $\tau_G$ des Tiefpass-Prototypfilters $G_1$ gebildet ist. Der Wert r berechnet gemäß Gleichung 5:

$$\text{Gleichung 5:} \quad r = (\tau_H + \tau_G)_I \; .$$

Der Operator ()$_I$ ist hierbei ein Modulo-Operator, durch den der Rest aus einer Division des Wertes in der Klammer durch die Anzahl I der Kanäle bestimmt wird. Der Wert r ist bevorzugt ein ganzzahliger Wert.

Die mittlere Gruppenlaufzeit $\tau_H$ ist dabei als Mittelwert der Gruppenlaufzeiten von $H_1$ für Frequenzen des Durchlass- und des Übergangsbereichs von $H_1$ berechnet. Entsprechendes gilt für $\tau_G$ in Bezug auf $G_1$. Die vorliegende Filterbankanordnung umfasst I = 64 Kanäle, die mittleren Gruppenlaufzeiten betragen $\tau_H = 44.11$ und $\tau_G = 52.25$. Damit ergibt sich als Rest für eine Division der Summe $\tau_H + \tau_G = 96.36$ durch I ein Wert von 32.36. Als nächstliegender ganzzahliger Wert ist somit r = 32 festgelegt.

Die beiden Tiefpass-Prototypfilter $H_1$ und $G_1$ sind FIR-Filter. Die komplexe Modulation des Prototypfilters $H_1$ und die Filterung des Eingangssignals X erfolgt bei der Analysefilterbank mittels einer IDFT. Entsprechend wird auch bei der Synthesefilterbank eine IDFT für die komplexe Modulation des Prototypfilters $G_1$ und die Filterung mittels einer IDFT durchgeführt.

Gemäß dem Graphen von FIG 4 beträgt die Gruppenlaufzeit $\tau(\Omega)$ der Filterbankanordnung für die meisten Frequenzen $\Omega$ ungefähr 96. Dieser Wert stellt die gewünschte Gruppenlaufzeit für die Filterbankanordnung mit komplexen Faktoren $\underline{F}_I$, l=1..I, dar. Die Filterbankanordnung weist eine höhere Gruppenlaufzeit auf als die dem Graphen von FIG 3 zugrunde liegende Filterbankanordnung. Für einen Benutzer des zugehörigen Hörgeräts ist allerdings auch bei einer Gruppenlaufzeit von 96 kein störender zeitlicher Versatz des Ausgangssignals Y zu demjenigen Schallsignal wahrnehmbar, das gegebenenfalls unprozessiert an das Trommelfell des Benutzers gelangt. Der Wert 96 für die Gruppenlaufzeit ergibt sich durch die komplexen Faktoren $\underline{F}_I$, l=1...I, anstelle der reellen Werte $F_I$, l=1...I.

Die Phasen eines jeden komplexen Faktors $\underline{F}_I$ ergibt eine Änderung der Gruppenlaufzeit in dem entsprechenden Kanal l, die zusammen mit den mittleren Gruppenlaufzeiten $\tau_H$ und $\tau_G$ der Filter $H_I$ und $G_I$, die den Kanal l bilden, eine gesamte mittlere Gruppenlaufzeit ergeben, die ein ganzzahliges Vielfaches der Anzahl I der Kanäle ist. Insgesamt wird bei der Filterbankanordnung dadurch bewirkt, dass die Abweichung der Gruppenlaufzeit $\tau(\Omega)$ an den Übergängen zwischen Kanälen mit unterschiedlichen Faktoren $F_I$ nur geringfügig von der gewünschten Gruppenlaufzeit 96 abweicht. Die Abweichung beträgt weniger als 10 Prozent. Damit ist für einen Benutzer des Hörgeräts keine signifikante Signalverzerrung hörbar.

Zusätzlich oder alternativ zu komplexen Faktoren $F_I$ kann auch vorgesehen sein, Paare von Filtern $H_I$ und $G_I$ zu verwenden, bei denen die Summe der mittleren Gruppenlaufzeit $\tau_H$ und $\tau_G$ ein ganzzahliges Vielfaches der Anzahl I der Kanäle beträgt, so dass $\tau_H + \tau_G = k\,I$ gilt, wobei k eine ganze Zahl ist. Gemäß Gleichung 5 ergibt sich dann ein Wert r=0, so dass die komplexen Faktoren $\underline{F}_I$ identisch mit den reellen Faktoren $F_I$ sind.

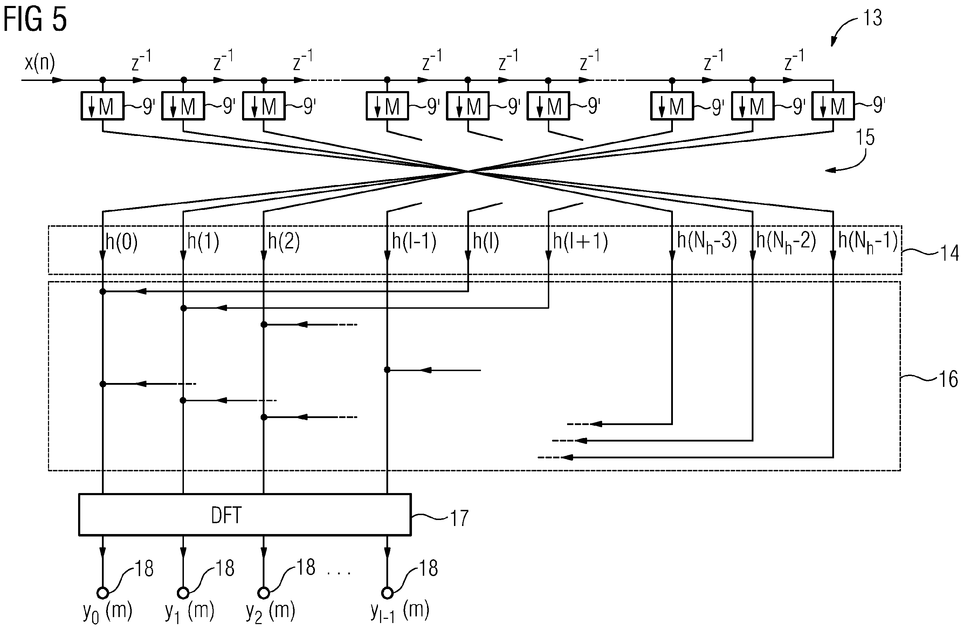

In FIG 5 ist ein Signalflussgraph einer Analysefilterbank 13 dargestellt. An einem Eingang der Analysefilterbank liegt ein aktueller digitaler Eingangswert x(n) zu einem momentanen Abtastzeitpunkt n an. An Ausgängen von Verzögerungselementen $z^{-1}$ sind weitere Eingangswerte x(n-1), x(n-2) usw. von vorangegangenen Abtastzeitpunkten n-1, n-2 usw. bereitgestellt. Insgesamt sind $N_h$ Eingangswerte zu einem bestimmten Abtastzeitpunkt n gespeichert.

Eine Taktreduzierung um den Faktor 1/M bewirkt, dass nur zu lediglich jedem M-ten Abtastzeitpunkt ein Satz von I=64 Ausgabewerten $y_0(m)$ bis $y_{I-1}(m)$ berechnet wird. Die geänderte Taktrate ist bei den Ausgabewerten $y_0(m)$ bis $y_{I-1}(m)$ durch einen neuen Zeitindex m anstelle von n angedeutet. Die Taktreduzierung selbst ist bei dem Signalflussgraphen von FIG 5 durch Taktreduzierer 9' symbolisiert. Vorliegend beträgt der Wert für die Taktreduktion M=16.

Die Folge der Eingangswerte x(n), x(n-1), x(n-2) usw. wird zum Berechnen der entsprechenden Ausgangswerte $y_0(m)$ bis $y_{I-1}(m)$ zunächst mit einer Folge von Filterkoeffizienten 14 multipliziert. Dazu wird die Folge der Eingangswerte x(n), x(n-1), x(n-2) zunächst mittels einer Umkehr-Operation 15 umgekehrt. Dadurch ergeben sich insgesamt die folgenden $N_h$ Multiplikationen: x(n) h($N_h$-1), x(n-1) h($N_h$-2), ..., x(n-$N_h$+1) h(0).

Anschließend werden durch Additionen 16 die Ergebnisse der Multiplikationen gemäß einer Polyphasen-Filterbank miteinander verknüpft, so dass sich insgesamt I Werte ergeben.

Aus diesen I Werten werden mittels einer diskreten Fourier-Transformation 17 die komplexen Ausgangwerte $y_0(m)$ bis $y_{I-1}(m)$ berechnet. Jeder der Ausgangwerte $y_0(m)$ bis $y_{I-1}(m)$ ist ein Wert für einen der insgesamt I Kanäle 18 einer Filterbankanordnung, in der die Analysefilterbank 13 eingesetzt ist. Im Vergleich mit einer Analysefilterbank, bei der die Umkehr-Operation 15 nicht vorgesehen ist und bei der anstelle einer diskreten Fourier-Transformation eine inverse Fourier-Transformation verwendet wird, weisen die komplexen Ausgangwerte $y_0(m)$ bis $y_{I-1}(m)$ der in FIG 5 dargestellten Analysefilterbank 13 eine Phase auf, die sich um einen Wert von -2 n (l-1) ($N_h$-1) / I unterscheidet, wobei l = 1...I den jeweiligen Kanal bezeichnet. In einem Kanal l wird dabei das Ausgangssignal $y_{I-1}(m)$ übertragen.

Die Filter der Analysefilterbank 13 und der entsprechenden, in FIG 5 nicht dargestellten Synthesefilterbank der Filterbankanordnung sind dabei so gewählt, dass der Wert r, der sich gemäß Gleichung 5 berechnet, gerade dem Wert $N_h$-1 entspricht. Damit wird durch die Umkehr-Operation 15 und durch Verwenden der diskreten Fourier-Transformation bewirkt, dass wie bei der Filterbank, die dem Graphen von FIG 4 zugrunde liegt und bei der komplexe Faktoren $\underline{F}_I$ verwendet werden, Gruppenlaufzeiten der Filterbankanordnung so geringfügig von einander abweichen, dass in einem prozessierten Signal kaum Verzerrungen wahrnehmbar sind.

Eine Verstärkung der einzelnen Ausgangswerte $y_0(m)$ bis $y_{l-1}(m)$ zum Ausgleichen eines Hörverlustes kann somit bei der Filterbankanordnung von FIG 5 durch reelle Werte $F_l$ bewirkt werden. Dies verringert die Anzahl von Rechenoperationen im Vergleich zu einer Multiplikation der Ausgangswerte $y_0(m)$ bis $y_{l-1}(m)$ mit komplexen Werten.

Anstelle der Umkehr-Operation 15 für die Folge von Eingangswerten x(n), x(n-1), x(n-2) kann auch eine Umkehr-Operation für die Folge von Filterkoeffizienten 14 vorgesehen sein. Des Weiteren kann vorgesehen sein, bei einer Synthesefilterbank Eingangswerte oder Filterkoeffizienten oder Ausgangswerte mit einer entsprechenden Umkehr-Operation umzukehren. Es kann auch eine Kombination der Umkehr-Operationen vorgesehen sein. Durch die Beispiele ist gezeigt, wie Mittel bereitgestellt werden können, um für eine Filterbankanordnung bei einem Ausgangssignal eine Verzerrung zu verringern, die aufgrund von Unterschieden in den Gruppenlaufzeiten der Filterbankanordnung für unterschiedliche Frequenzen hervorgerufen werden.

**Patentansprüche**

1. Filterbankanordnung für eine Hörvorrichtung, bei der Filter ($H_1$, $H_l$, $H_l$) einer Analysefilterbank (6) mit entsprechenden Filtern ($G_1$, $G_l$, $G_l$) einer Synthesefilterbank (7) paarweise gekoppelt sind, wobei durch jedes Paar der gekoppelten Filter ein Kanal (18) gebildet ist,
   wobei für wenigstens einen derartig gebildeten Kanal Mittel (12, 15, 17) vorgesehen sind, um eine Phase eines über den Kanal übertragenen Signals derart zu verändern, dass eine Differenz zwischen einer Gruppenlaufzeit ($\tau(\Omega)$) der Filterbankanordnung und einem vorgebbaren Sollwert für wenigstens eine vorbestimmte Frequenz reduziert wird;
   wobei wenigstens ein Filter ($H_1$, $H_l$, $H_l$) der Analysefilterbank (6) über eine Skalierungseinrichtung (12) mit dem entsprechenden Filter ($G_1$, $G_l$, $G_l$) der Synthesefilterbank (7) gekoppelt ist, wobei mittels der Skalierungseinrichtung (12) ein Teilbandsignal mit einem Faktor ($\underline{F}_l$) multiplizierbar ist, und
   als Mittel zum Verändern der Phase bei der Skalierungseinrichtung der Faktor ($\underline{F}_l$) einem komplexen Wert entspricht, dessen Phase derart bestimmt ist, dass für die wenigstens eine vorbestimmte Frequenz die Differenz zwischen der Gruppenlaufzeit($\tau(\Omega)$) der Filterbankanordnung und dem vorgebbaren Sollwert reduziert wird,
   **dadurch gekennzeichnet, dass**
   bei der Skalierungseinrichtung die Phase des Faktors abhängig von einer Summe aus einer mittleren Gruppenlaufzeit ($\tau_H$) des zugeordneten Filters der Analysefilterbank und einer mittleren Gruppenlaufzeit ($\tau_G$) des entsprechenden Filters der Synthesefilterbank bestimmt ist, wobei die mittleren Gruppenlaufzeiten jeweils ein Mittelwert der Gruppenlaufzeiten des jeweiligen Filters für Frequenzen in einem Durchlassbereich sowie einem Übergangsbereich sind, wobei eine durch die Phase des Faktors bewirkte Verzögerung eines über die Skalierungseinrichtung übertragenen Teilbandsignals zusammen mit der Summe der mittleren Gruppenlaufzeiten einem Wert entspricht, der ein ganzzahliges Vielfaches der Anzahl (I) der Kanäle (18) der Filterbankanordnung ist.

2. Filterbankanordnung nach Anspruch 1,
   **dadurch gekennzeichnet, dass**
   die Analysefilterbank eine komplex-modulierte Polyphasenfilterbank mit einem ersten Prototypfilter ist, aus dem die Filter der Analysefilterbank jeweils in Abhängigkeit von einem Kennwert für den Kanal gebildet werden, und dass die Synthesefilterbank eine komplex-modulierte Polyphasenfilterbank mit einem zweiten Prototypfilter ist, und dass bei der Skalierungseinrichtung die Phase des Faktors abhängt von

   - dem Kennwert (I) für den Kanal,
   - der Anzahl (I) der Kanäle der Filterbankanordnung und
   - der Summe aus der mittleren Gruppenlaufzeit ($\tau_H$) des ersten Prototypfilters und der mittleren Gruppenlaufzeit($\tau_G$) des zweiten Prototypfilters ist.

3. Filterbankanordnung nach Anspruch 2,
   **dadurch gekennzeichnet, dass**
   das erste Prototypfilter ($H_1$) und das zweite Prototypfilter ($G_1$) jeweils ein FIR-Filter, insbesondere ein linearphasiges FIR-Filter, ist.

4. Filterbankanordnung nach einem der vorhergehenden Ansprüche,
   **dadurch gekennzeichnet, dass**
   bei wenigstens einem Paar der gekoppelten Filter das Filter der Analysefilterbank und das Filter der Synthesefilterbank jeweils ein FIR-Filter ist und die Summe ($\tau_H + \tau_G$) aus den mittleren Gruppenlaufzeiten der beiden Filter ein

ganzzahliges Vielfaches (kl) der Anzahl (I) der Kanäle der Filterbankanordnung ist.

5. Filterbankanordnung nach einem der vorhergehenden Ansprüche,
   **dadurch gekennzeichnet, dass**
   bei wenigstens einem Paar der gekoppelten Filter das Filter der Analysefilterbank und das Filter der Synthesefilterbank jeweils ein linearphasiges FIR-Filter ist, wobei die Summe aus der Filterordnung des FIR-Filters der Analysefilterbank und der Filterordnung des FIR-Filters der Synthesefilterbank ein ganzzahliges Vielfaches der doppelten Anzahl der Kanäle der Filterbankanordnung ist.

6. Filterbankanordnung nach einem der vorhergehenden Ansprüche,
   **dadurch gekennzeichnet, dass**
   als Mittel zum Verändern der Phase bei wenigstens einem Paar der gekoppelten Filter als ein erstes Filter des Paares ein FIR-Filter vorgesehen ist, das durch eine Folge von Koeffizienten bestimmt ist, welche sich ergibt, wenn eine Folge von Koeffizienten eines FIR-Filters umgekehrt wird, das einem auf das zweite Filter des Paares abgestimmten Filter entspricht.

7. Filterbankanordnung nach Anspruch 6,
   **dadurch gekennzeichnet, dass**
   wenigstens eine der Filterbänke eine Einrichtung zum Berechnen einer diskreten Fourier-Transformation aufweist.

8. Filterbankanordnung nach einem der vorhergehenden Ansprüche,
   **gekennzeichnet durch**
   wenigstens eine komplex-modulierte, gleichförmige Filterbank, bei der Filter der Filterbank aus einem Prototypfilter jeweils durch eine komplexe Modulation mittels einer DFT oder IDFT gebildet sind, wobei die Filterbank dazu ausgebildet ist, als Mittel zum Verändern der Phase eine Reihenfolge von Werten eines Eingangssignals und/oder eines Ausgangssignals einer Einrichtung zum Berechnen der DFT oder IDFT umzukehren.

9. Filterbankanordnung nach einem der vorhergehenden Ansprüche,
   **dadurch gekennzeichnet, dass**
   bei allen Paaren der gekoppelten Filter die Summe aus der mittleren Gruppenlaufzeit des Filters der Analysefilterbank und der mittleren Gruppenlaufzeit des entsprechenden Filters der Synthesefilterbank gleich ist.

10. Filterbankanordnung nach Anspruch 9,
    **dadurch gekennzeichnet, dass**
    die Summe aus den mittleren Gruppenlaufzeiten ein ganzzahliges Vielfaches der Anzahl der Kanäle ist.

## Claims

1. Filter bank arrangement for a hearing device, in which filters ($H_1$, $H_l$, $H_I$) in an analysis filter bank (6) and corresponding filters ($G_1$, $G_l$, $G_I$) in a synthesis filter bank (7) are coupled in pairs, with each pair of coupled filters forming a channel (18), wherein means (12, 15, 17) are provided for at least one channel formed in this fashion in order to change a phase of a signal transmitted by the channel such that a difference between a group delay ($\tau(\Omega)$) of the filter bank arrangement and a prescribable reference value is reduced for at least one predetermined frequency; wherein at least one filter ($H_1$, $H_l$, $H_I$) in the analysis filter bank (6) is coupled to the corresponding filter ($G_1$, $G_l$, $G_I$) in the synthesis filter bank (7) via a scaling apparatus (12), wherein the scaling apparatus (12) can be used to multiply a sub-band signal by a factor ($\underline{F}_l$), and the factor ($\underline{F}_l$), as means for changing the phase in the scaling apparatus, corresponds to a complex value, the phase of which is determined such that the difference between the group delay ($\tau(\Omega)$) of the filter bank arrangement and the prescribable reference value is reduced for the at least one predetermined frequency,
   **characterized**
   **in that** in the scaling apparatus the phase of the factor is determined as a function of a sum of a mean group delay ($\tau_H$) of the assigned filter in the analysis filter bank and a mean group delay ($\tau_G$) of the corresponding filter in the synthesis filter bank, wherein the mean group delays respectively are a mean value of the group delays of the respective filter for frequencies in a pass band and in a roll-off band, wherein a delay, caused by the phase of the factor, of a sub-band signal transmitted via the scaling apparatus, together with the sum of the mean group delays, corresponds to a value that is an integer multiple of the number (I) of channels (18) in the filter bank arrangement.

**2.** Filter bank arrangement according to Claim 1,
**characterized**
**in that** the analysis filter bank is a complex-modulated polyphase filter bank with a first prototype filter, from which the filters in the analysis filter bank are respectively formed as a function of a characteristic value for the channel, and in that the synthesis filter bank is a complex-modulated polyphase filter bank with a second prototype filter, and in that,
in the scaling apparatus, the phase of the factor depends on

- the characteristic value (1) for the channel,
- the number (I) of channels in the filter bank arrangement, and
- the sum of the mean group delay ($\tau_H$) of the first prototype filter and the mean group delay ($\tau_G$) of the second prototype filter.

**3.** Filter bank arrangement according to Claim 2,
**characterized**
**in that** the first prototype filter ($H_1$) and the second prototype filter ($G_1$) each are a FIR filter, more particularly a linear-phase FIR filter.

**4.** Filter bank arrangement according to one of the preceding claims,
**characterized**
**in that** the filter in the analysis filter bank and the filter in the synthesis filter bank each are a FIR filter in at least one pair of coupled filters, and the sum ($\tau_G + \tau_H$) of the mean group delays of the two filters is an integer multiple (kI) of the number (I) of channels in the filter bank arrangement.

**5.** Filter bank arrangement according to one of the preceding claims,
**characterized**
**in that** the filter in the analysis filter bank and the filter in the synthesis filter bank each are a linear-phase FIR filter in at least one pair of coupled filters, with the sum of the filter order of the FIR filter in the analysis filter bank and the filter order of the FIR filter in the synthesis filter bank being an integer multiple of double the number of channels in the filter bank arrangement.

**6.** Filter bank arrangement according to one of the preceding claims,
**characterized**
**in that** a FIR filter is provided as a first filter of the pair as means for changing the phase in at least one pair of coupled filters, which FIR filter is determined by a sequence of coefficients that is the result of reversing a sequence of coefficients of a FIR filter, which corresponds to a filter matched to the second filter of the pair.

**7.** Filter bank arrangement according to Claim 6,
**characterized**
**in that** at least one of the filter banks has an apparatus for calculating a discrete Fourier transform.

**8.** Filter bank arrangement according to one of the preceding claims,
**characterized**
**by** at least one complex-modulated, uniform filter bank, in which filters in the filter bank are made of a prototype filter in each case formed by a complex modulation by means of a DFT or IDFT, wherein the filter bank as means for changing the phase is designed to reverse a sequence of values of an input signal and/or an output signal from an apparatus for calculating the DFT or IDFT.

**9.** Filter bank arrangement according to one of the preceding claims,
**characterized**
**in that** the sum of the mean group delay of the filter in the analysis filter bank and the mean group delay of the corresponding filter in the synthesis filter bank is equal in all pairs of coupled filters.

**10.** Filter bank arrangement according to Claim 9,
**characterized**
**in that** the sum of the mean group delays is an integer multiple of the number of channels.

**Revendications**

1. Agencement de bancs de filtrage pour un dispositif d'audition, sur lequel des filtres ($H_1$, $H_l$, $H_l$) d'un banc de filtrage d'analyse (6) sont couplés par paires à des filtres ($G_1$, $G_l$, $G_l$) correspondants d'un banc de filtrage de synthèse (7), chaque paire des filtres couplés formant un canal (18),
   pour au moins un canal formé de cette sorte étant prévus des moyens (12, 15, 17) pour modifier une phase d'un signal transmis par l'intermédiaire du canal, de telle sorte qu'une différence entre un temps de propagation de groupe ($\tau(\Omega)$) de l'agencement de bancs de filtrage et une valeur de consigne prédéfinissable se réduise pour au moins une fréquence prédéterminée ;
   au moins un filtre ($H_1$, $H_l$, $H_l$) du banc de filtrage d'analyse (6) étant couplé par l'intermédiaire d'un système de mise à l'échelle (12) avec le filtre ($G_1$, $G_l$, $G_l$) correspondant du banc de filtrage de synthèse (7), un signal de sous-bande étant multipliable par un coefficient ($\underline{F}_l$) au moyen du système de mise à l'échelle (12),
   et
   en tant que moyen de modification de la phase, pour le système de mise à l'échelle, le coefficient ($\underline{F}_l$) correspondant à une valeur complexe, dont la phase est déterminée de telle sorte que pour l'au moins une fréquence prédéfinie, la différence entre le temps de propagation de groupe ($\tau(\Omega)$) de l'agencement de bancs de filtrage et la valeur de consigne prédéfinissable se réduise, **caractérisé en ce que** pour le système de mise à l'échelle, la phase du coefficient est déterminée en fonction d'une somme d'un temps de propagation de groupe ($\tau_H$) moyen du filtre associé du banc de filtrage d'analyse et d'un temps de propagation de groupe ($\tau_G$) moyen du filtre correspondant du banc de filtrage de synthèse, les temps de propagation de groupe moyens étant respectivement une valeur moyenne des temps de propagation de groupe du filtre respectif pour des fréquences dans une bande passante ainsi que dans une bande transitoire,
   une temporisation d'un signal de sous-bande transmis par l'intermédiaire du système de mise à l'échelle, provoquée par la phase du coefficient, correspondant, ensemble avec la somme des temps de propagation de groupe moyens, à une valeur qui est un multiple entier du nombre (I) des canaux (18) de l'agencement de bancs de filtrage.

2. Agencement de bancs de filtrage selon la revendication 1,
   **caractérisé en ce que** le banc de filtrage d'analyse est un banc de filtrage polyphasé à modulation complexe, avec un premier filtre prototype à partir duquel les filtres du banc de filtrage d'analyse sont formés chaque fois en fonction d'une valeur caractéristique pour le canal, et **en ce que**
   le banc de filtrage de synthèse est un banc de filtrage polyphasé à modulation complexe, avec un deuxième filtre prototype, et **en ce que** pour le système de mise à l'échelle, la phase du coefficient dépend

   - de la valeur caractéristique (1) pour le canal,
   - du nombre (I) de canaux de l'agencement de bancs de filtrage et
   - de la somme du temps de propagation de groupe ($\tau_H$) moyen du premier filtre prototype et du temps de propagation de groupe ($\tau_G$) moyen du deuxième filtre prototype.

3. Agencement de bancs de filtrage selon la revendication 2, **caractérisé en ce que** le premier filtre prototype ($H_1$) et le deuxième filtre prototype ($G_1$) sont à chaque fois un filtre FIR, notamment un filtre FIR à phase linéaire.

4. Agencement de bancs de filtrage selon l'une quelconque des revendications précédentes,
   **caractérisé en ce que**
   pour au moins une paire des filtres couplés, le filtre du banc de filtrage d'analyse et le filtre du banc de filtrage de synthèse sont à chaque fois un filtre FIR et la somme ($\tau_H + \tau_G$) des temps de propagation de groupe moyens des deux filtres est un multiple entier (kI) du nombre (I) de canaux de l'agencement de bancs de filtrage.

5. Agencement de bancs de filtrage selon l'une quelconque des revendications précédentes,
   **caractérisé en ce que**
   pour au moins une paire des filtres couplés, le filtre du banc de filtrage d'analyse et le filtre du banc de filtrage de synthèse sont à chaque fois un filtre FIR à phase linéaire, la somme de l'ordre de filtrage du filtre FIR du banc de filtrage d'analyse et de l'ordre de filtrage du filtre FIR du banc de filtrage de synthèse étant un multiple entier du double du nombre de canaux de l'agencement de bancs de filtrage.

6. Agencement de bancs de filtrage selon l'une quelconque des revendications précédentes,
   **caractérisé en ce**
   **qu'**en tant que moyen de modification de la phase pour au moins une paire des filtres couplés, en tant que premier filtre de la paire, il est prévu un filtre FIR, qui est déterminé par une séquence de coefficients qui résulte d'une inversion d'une séquence de coefficients d'un filtre FIR qui correspond à un filtre adapté au deuxième filtre de la paire.

7. Agencement de bancs de filtrage selon la revendication 6, **caractérisé en ce qu'**au moins l'un des bancs de filtrage comporte un système destiné à calculer une transformation de Fourier discrète.

8. Agencement de bancs de filtrage selon l'une quelconque des revendications précédentes, **caractérisé par** au moins un banc de filtrage uniforme à modulation complexe, sur lequel des filtres du banc de filtrage sont formés à partir d'un filtre prototype, chaque fois par une modulation complexe au moyen d'une TFD ou d'une TFDI, le banc de filtrage étant conçu pour inverser, en tant que moyen de modification de la phase, une séquence de valeurs d'un signal d'entrée et/ou d'un signal de sortie d'un système destiné à calculer la TFD ou la TFDI.

9. Agencement de bancs de filtrage selon l'une quelconque des revendications précédentes, **caractérisé en ce que** pour toutes les paires des filtres couplés, la somme du temps de propagation de groupe moyen du filtre du banc de filtrage d'analyse et du temps de propagation de groupe moyen du filtre correspondant du banc de filtrage de synthèse est égale.

10. Agencement de bancs de filtrage selon la revendication 9, **caractérisé en ce que** la somme des temps de propagation de groupe moyens est un multiple entier du nombre de canaux.

FIG 1
(Stand der Technik)

FIG 2

## FIG 3

(Stand der Technik)

$\tau(\Omega)$

120

64

12    20    27    35

I

## FIG 4

$\tau(\Omega)$

104

96

12    20    27    35

I

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050185798 A1

- US 20070276656 A1

**In der Beschreibung aufgeführte Nicht-Patentliteratur**

- A flexible filterbank structure for extensive signal manipulations in digital hearing aids. **BRENNAN R et al.** CIRCUIT AND SYSTEMS. ISCAS, 1998, vol. 98
- PROCEEDINGS OF THE 1998 IEEE INTERNATIONAL SYMPOSION ON MONTEREY. IEEE, 31. Mai 1998, vol. 6, 569-572

- Iterative method for the design of DFT filter bank. **H.H. DAM ; S. NORDHOLM ; A. CANTONI ; J.M. DE HAAN.** Transactions on Circuits and Systems II: Express Briefs. IEEE, 11. November 2004, vol. 51, 581-586